# EUROPEAN PATENT APPLICATION

(11) **EP 3 828 561 A1**
(43) Date of publication of application: **02.06.2021**
(21) Application number: 20204018.4
(22) Date of filing: 27.10.2020
(51) Int. Cl.: G01R 31/00

(54) **DETECTING DISCRETE INPUTS OF AN AIRCRAFT**

(30) Priority: 28.11.2019 IN 201911048845
(71) Applicant: Hamilton Sundstrand Corporation, Charlotte, NC 28217-4578 (US)
(72) Inventor: PENNAM, Hemanth Kumar, 517588 Andhra Pradesh (IN)
(74) Representative: Dehns

(57) **Abstract**

Provided are embodiments for a circuit (100) for detecting discrete inputs. The circuit includes a power source(106;108;124), a diode set (112) coupled to the power source, a line replaceable unit (LRU) circuit (102), and a logic detection and processing circuit (114) that is operably connected to the first LRU, wherein the logic detection and processing circuit is configured to detect a state of the LRU based on a detected voltage. Also, provided are embodiments of a method (200) for operating a logic detection and processing circuit.

## Description

### CROSS-REFERENCE TO RELATED APPLICATIONS

This application claims the benefit of Indian Application No. 201911048845 filed November 28, 2019.

### BACKGROUND

The present disclosure relates generally to circuits, and more specifically to a circuit and enhanced method for detecting discrete inputs of an aircraft.

Aircraft are equipped with a number of detection circuits that can provide various types of information. This information can indicate whether a device is connected or disconnected. In addition, the information can also indicate whether the device is in an operational state or a failed state. The detection circuits are configured to function over a limited operating range. There may be a need to increase the operating range and reliability of the detection circuits.

### BRIEF DESCRIPTION

According to an embodiment, a circuit for detecting discrete inputs is provided. The circuit includes a power source; a diode set coupled to the power source; a line replaceable unit (LRU) circuit; and a logic detection and processing circuit that is operably connected to the first LRU, wherein the logic detection and processing circuit is configured to detect a state of the LRU based on a detected voltage.

In addition to one or more of the features described herein, or as an alternative, further embodiments include a diode set comprises at least one diode.

In addition to one or more of the features described herein, or as an alternative, further embodiments include a Zener diode.

In addition to one or more of the features described herein, or as an alternative, further embodiments include a voltage drop across the Zener diode that remains constant during operation.

In addition to one or more of the features described herein, or as an alternative, further embodiments include a protection diode.

In addition to one or more of the features described herein, or as an alternative, further embodiments include a protection diode is reverse biased during a negative overcurrent event.

In addition to one or more of the features described herein, or as an alternative, further embodiments include a power source that is provided from a generator.

In addition to one or more of the features described herein, or as an alternative, further embodiments include a power source that is provided from an external power source.

In addition to one or more of the features described herein, or as an alternative, further embodiments include an LRU that is selectably connected to logic detection and processing circuit using a switch.

In addition to one or more of the features described herein, or as an alternative, further embodiments include an LRU that includes a diode configured to provide forward bias protection to the logic detection and processing circuit.

According to another embodiment, a method of operating a logic detection and processing circuit is provided. The method includes operating the logic detection and processing circuit configured to detect a state of an line replaceable unit (LRU); providing power to a circuit; receiving a discrete input; detecting, by a logic detection and protection circuit, the discrete input over a path that maintains a constant voltage; and processing, logic detection and processing logic, the discrete input.

In addition to one or more of the features described herein, or as an alternative, further embodiments include a diode set, wherein the diode set includes at least one Zener diode.

In addition to one or more of the features described herein, or as an alternative, further embodiments include a protection diode.

In addition to one or more of the features described herein, or as an alternative, further embodiments include switching the circuit from a first mode to a second mode.

In addition to one or more of the features described herein, or as an alternative, further embodiments include a first mode that is powered by a generator.

In addition to one or more of the features described herein, or as an alternative, further embodiments include maintaining the constant voltage drop over a range of operation of the generator.

In addition to one or more of the features described herein, or as an alternative, further embodiments include a second mode that is powered by an external power source.

In addition to one or more of the features described herein, or as an alternative, further embodiments include maintaining the constant voltage drop when operating in the second mode.

In addition to one or more of the features described herein, or as an alternative, further embodiments include protecting the circuit during a negative over-current event.

In addition to one or more of the features described herein, or as an alternative, further embodiments include protecting the circuit during a positive over-current event.

Technical effects of embodiments of the present disclosure include enabling an enhanced range for operating a logic detection and processing circuit. In addition, protections for overcurrent and overvoltage conditions are provided.

The foregoing features and elements may be combined in various combinations without exclusivity, unless expressly indicated otherwise. These features and elements, as well as the operation thereof, will become more apparent in light of the following description and the accompanying drawings. It should be understood, however, that the following description and drawings are intended to be illustrative and explanatory in nature and non-limiting.

### BRIEF DESCRIPTION OF THE DRAWINGS

The following descriptions should not be considered limiting in any way. With reference to the accompanying drawings, like elements are numbered alike:
FIG. 1 depicts a circuit for detecting a discrete input in accordance with one or more aspects of the disclosure;
FIG. 2 depicts a method for operating the circuit to detect a discrete input in accordance with one or more aspects of the disclosure; and
FIG. 3 depicts an aircraft that can include the circuit of FIG. 1 in accordance with one or more aspects of the disclosure.

### DETAILED DESCRIPTION

Generators can produce power using a variable input that can impact the power that provided to the connected circuits and systems. The generator can be a permanent magnet generator (PMG) that is driven by an engine, such as an aircraft of an engine. A logic detection and processing circuit can be powered over a limited operating range such as an operating range of 18 V to 32.2 V.

During a ramped down phase of the generator, the power that is derived from the generator can be reduced to a level, such as 13.2 VDC which is below the typical operating range of 18V. This can create the problem of detecting a discrete input open status (Logic High detection by a sense circuit) of a connected line replaceable unit (LRU). When the aircraft is grounded, the power source can be connected to an external power source such as an alternating current (AC) ground cart. During such an event, the source voltage can be increased beyond the normal operating range (e.g., 37.4 VDC) due to an over-voltage condition responsive to be connected to an external power AC source.

Conventional systems are largely susceptible to the voltage level detected at the sense circuit input, and may not be able to detect the proper state due to the power operating outside of the limited operating range of the circuit. The techniques described herein provide a detection path between the LRU and the detection circuit that maintains a constant voltage drop to enhance the operating voltage of the detection circuit.

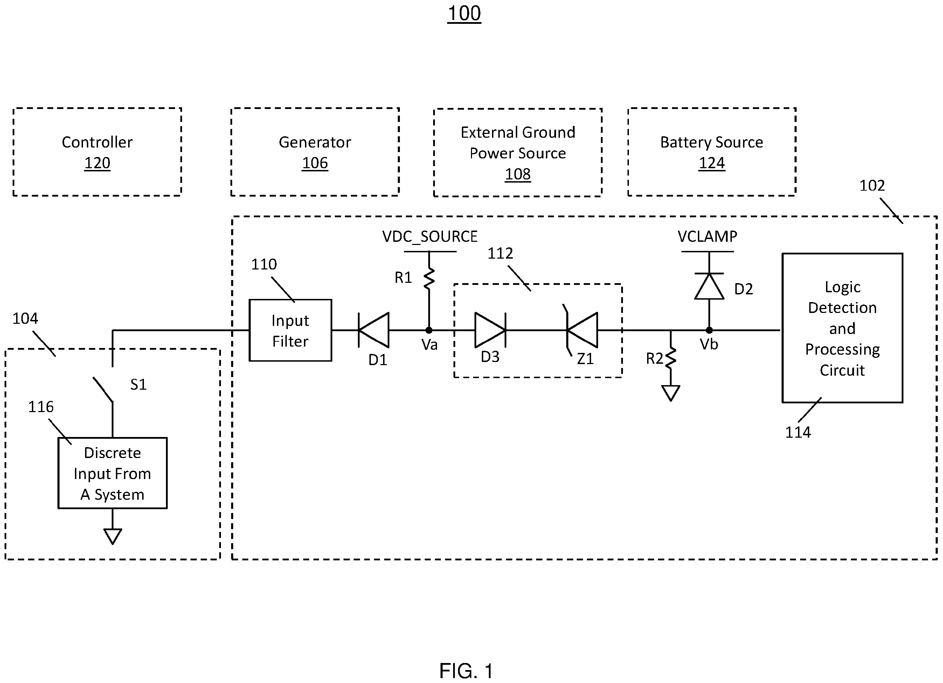

FIG. 1 depicts a circuit 100 used for detecting discrete aircraft inputs in accordance with one or more embodiments. In a non-limiting example, a discrete input can be obtained by a line replacement unit (LRU) 102 including a sensing circuit and provided to a logic detection and processing circuit of an LRU 104 including a discrete input circuit 116. The LRU 102 receives power from a VDC_Source. The VDC_Source can be derived from a generator 106, an external ground power source 108, or battery source 124.

In one or more embodiments, the LRU 104 can include a discrete input from an aircraft. In one or more embodiments, the discrete inputs can be either open or grounded. That is, the GCU is unable to sense the ground condition. The LRU 104 also includes a switch that can be controlled to provide the discrete signal to LRU 104.

The LRU 102 includes a number of components and it should be understood that it is not limited by that disclosed in FIG. 1. The LRU 102 includes a logic detection and processing circuit 114, input filter 110, voltage input, and a number of passive circuit elements.

The LRU 102 can include an input filter 110 to filter out noise from the input signal from the LRU 102. It should be understood the input filter 110 can include a number of passive components such as resistors, capacitors, and inductors to filter the input, or the input filter 110 can include active switching components that can be used to filter the input signal. In another embodiment, the input filter 110 can be coupled to a single LRU to filter the input signal.

The LRU 102 includes the logic detection and processing circuit 114 to process the discrete signal received from the LRU 104. The discrete signal can be received at an input filter 110.

As shown, the logic detection and processing circuit 114 is coupled to the node Vb and is configured to detect the discrete input by changes in the voltage detected and the Vb node. The voltage at the node Vb is dependent on the resistor R1, the diode set 112, and the resistor R2. The selection of the values for resistors R1 and R2 should be sized to meet the associated source current requirements for a discrete input at the ground state. In addition, the higher the value for the resistor R2 causes leakage current.

The LRU 102 also includes a diode D1, where the anode of the diode D1 is coupled to the node Va and the cathode of the diode is coupled to the input filter 110. The diode D1 can be used for protection. The diode D1 can be a Schottky diode and have a low forward voltage drop and a very fast switching action. It should be understood that diodes of the circuit can be a Schottky diode or any other type of diode.

The input filter 110 is selectively coupled to the LRU 104 using a switch S1. The switch S1 can be closed and opened by a controller 120 which can detect the state of the discrete input circuit 116.

The VDC_Source can be derived from the generator 106. In another embodiment, the VDC_Source can be derived from an external power source 108. The VDC_Source is coupled to the node Va through the resistor R1. The resistor R1 can be sized to ensure that sufficient current flow is available to operate the circuit 100.

Conventional techniques simply implement a single resistor R in place of the diode set 112. Challenges may arise due to a change in the VDC_Source which can impact the voltage drop across the resistor R2. In particular, conventional circuits and techniques connect the resistor R between the Va node and the Vb node. The voltage drop across the resistor R is linear and increases with the increase in voltage. The changes in the VDC can be caused by a number of reasons and can render the logic detection and processing circuit 114 inoperable.

For example, the voltage at the node Vb may be increased when connected to the external power source 108. In such an event, the logic detection and processing circuit 114 may not be able to be detect the state. That is, a logic low detection may not be detected by the sense circuit.

On the other hand, the voltage at the Vb node may be reduced to the point where the discrete input level cannot be detected by the logic detection and processing circuit 114 during an engine spin-down causing a reduced input voltage. Because of the low voltage that is below the operating range, the reduced voltage can prevent the detection of the state of the discrete input.

The techniques described herein, implement a diode set 112. The diode set 112 includes a Zener diode Z1 which maintains a constant voltage drop across an increased operating range. Zener diodes permit current to flow in both the forward or reverse direction. The Zener diode Z1 only permits current flow in the reverse direction when a threshold voltage is reached. In a non-limiting example, the voltage drop across the Zener diode Z1 maintains a constant voltage drop over a power supply range. The anode of the Zener diode Z1 is connected to the node Vb and the cathode of the Zener diode is connected to the diode D3.

In one or more embodiments, the diode set 112 can also include a diode D3. The anode of the diode is connected to the node Va and the cathode is connected to the cathode of the Zener diode Z1. The diode D3 protects the logic detection and processing circuit 114 and also protects negative overcurrent condition for the remaining circuit.

The logic detection and processing circuit 114 detects the discrete input based on the inputs that are received from the LRU 104 when connected by the switch S1.

The circuit 100 can also include a VCLAMP that is coupled to the node Vb through a diode D2, where the anode of the diode D2 is connected to the node Vb and the cathode of the diode D2 is connected to the VCLAMP

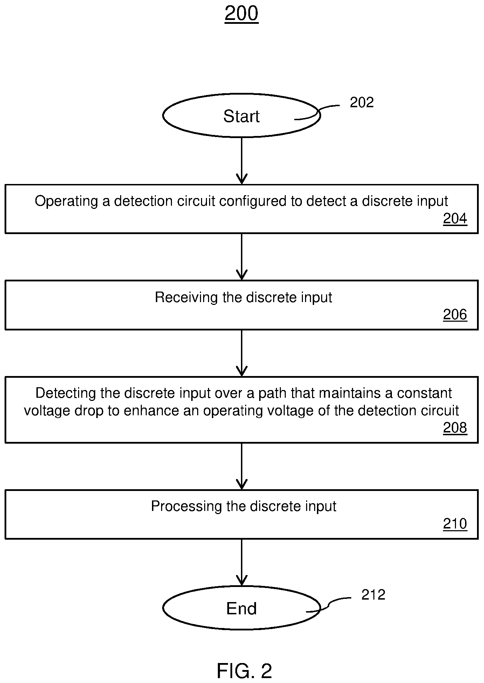

FIG. 2 depicts a method 200 for operating the circuit for detecting discrete inputs in accordance with one or more embodiments of the disclosure. The method 200 begins at block 202 and proceeds to block 204 which provides for operating a detection circuit for detecting the discrete input. In one or more embodiments, the power source of the circuit can be switched from the generator power to the external power. In the event an overvoltage condition is detected, issues may arise when detecting discrete input ground status.

Block 206 receives the discrete input. The discrete input can be coupled to the logic detection and processing circuit 114. For example, a generator control signal (GCS) is a discrete input signal, which is under the pilot's control which will be used to reset the generator control unit (GCU) LRU. In the conventional method, a pilot fails to reset the GCU LRU when required during a low power or high power conditions occurs outside of the limited operating range.

Block 208 detects the discrete input over a path that maintains a constant voltage drop to enhance the operating voltage of the detection circuit. The path includes a Zener diode that has a constant voltage drop over an operating range of the circuit. For example, when the voltage supply provided by a generator changes, the logic detection and processing circuit is able to detect the state of the connected LRU. If the voltage is increased responsive to being connected to an external power source, the logic detection and processing circuit 114 is still able to detect the state.

Block 210 processes the discrete input. The logic detection and processing circuit 114 can determine the state provided by the discrete input. The method 200 ends at block 212.

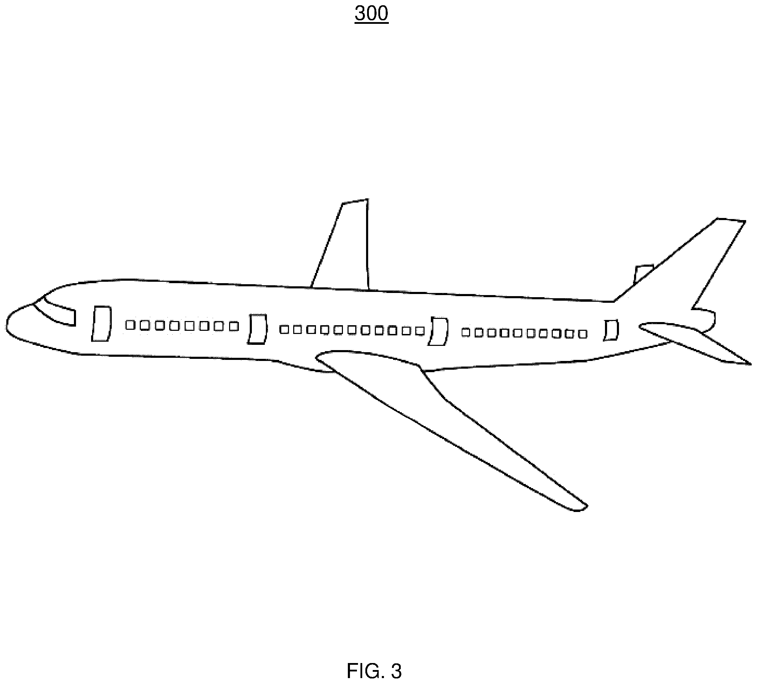

FIG. 3 depicts an aircraft 300 that can incorporate the circuit 100 shown in FIG. 1. It should be understood the circuit 100 can be implemented in other types of system for discrete input detection and is not limited by the example shown in FIG. 3.

The technical effects and benefits provide an increased discrete input detection range. The operating voltage range is enhanced to detect the discrete input state without changing the existing AC to direct current (DC) conversion circuit used in the LRUs. The circuit and methods are universal and can be used for any type of discrete input detection. The technical effects and benefits can provide an increased battery lifetime due to reduced power consumption when the LRU is driven by a battery source. The technical effects and benefits include efficiently estimating the working voltage range of the circuit, due to the voltage drop across the Zener diode is almost constant. Also, the technical effects and benefits include providing negative over current protection during such an event.

As described above, embodiments can be in the form of processor-implemented processes and devices for practicing those processes, such as a processor. Embodiments can also be in the form of computer program code containing instructions embodied in tangible media, such as network cloud storage, SD cards, flash drives, floppy diskettes, CD ROMs, hard drives, or any other computer-readable storage medium, wherein, when the computer program code is loaded into and executed by a computer, the computer becomes a device for practicing the embodiments. Embodiments can also be in the form of computer program code, for example, whether stored in a storage medium, loaded into and/or executed by a computer, or transmitted over some transmission medium, loaded into and/or executed by a computer, or transmitted over some transmission medium, such as over electrical wiring or cabling, through fiber optics, or via electromagnetic radiation, wherein, when the computer program code is loaded into an executed by a computer, the computer becomes an device for practicing the embodiments. When implemented on a general-purpose microprocessor, the computer program code segments configure the microprocessor to create specific logic circuits.

A detailed description of one or more embodiments of the disclosed apparatus and method are presented herein by way of exemplification and not limitation with reference to the Figures.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the present disclosure. In addition, many modifications may be made to adapt a particular situation or material to the teachings of the present disclosure without departing from the essential scope thereof. Therefore, it is intended that the present disclosure not be limited to the particular embodiment disclosed as the best mode contemplated for carrying out this present disclosure, but that the present disclosure will include all embodiments falling within the scope of the claims.

## Claims

1. A circuit (100) for detecting discrete inputs, the circuit comprising:
a power source (106;108;124);
a diode set (112) coupled to the power source;
a line replaceable unit, LRU, circuit; and
a logic detection and processing circuit (114) that is operably connected to the first LRU, wherein the logic detection and processing circuit is configured to detect a state of the LRU based on a detected voltage.

2. The circuit of claim 1, wherein the diode set comprises at least one diode.

3. The circuit of claim 2, wherein the at least one diode of the diode set is a Zener diode (Z1); optionally wherein a voltage drop across the Zener diode remains constant during operation.

4. The circuit of claim 2, wherein the at least one diode of the diode set is a protection diode (D3); optionally wherein the protection diode is reverse biased during a negative overcurrent event.

5. The circuit of any preceding claim, wherein the power source is provided from a generator (106).

6. The circuit of any of claims claim 1 to 4, wherein the power source is provided from an external power source (108;124).

7. The circuit of any preceding claim, wherein the LRU is selectably connected to logic detection and processing circuit using a switch (S1).

8. The circuit of any preceding claim, wherein the LRU comprises a diode configured to provide forward bias protection to the logic detection and processing circuit.

9. A method (200) of operating a logic detection and processing circuit (114), the method comprising:
operating (204) the logic detection and processing circuit configured to detect a state of a line replaceable unit, LRU, (102);
providing power to a circuit;
receiving (206) a discrete input;
detecting (208), by a logic detection and protection circuit, the discrete input over a path that maintains a constant voltage; and
processing (210), by the logic detection and processing circuit (114), the discrete input.

10. The method of claim 9, wherein the path comprises a diode set (112), wherein the diode set comprises at least one Zener diode (Z1); optionally wherein the diode set comprises a protection diode (D3).

11. The method of claim 9 or 10, further comprising switching the circuit from a first mode to a second mode.

12. The method of claim 11, wherein the first mode is powered by a generator; optionally further comprising maintaining the constant voltage drop over a range of operation of the generator (106).

13. The method of claim 11, wherein the second mode is powered by an external power source (108; 124); optionally further comprising maintaining the constant voltage drop when operating in the second mode.

14. The method of any of claims 9 to 13, further comprising protecting the circuit during a negative over-current event.

15. The method of any of claims 9 to 14, further comprising protecting the circuit during a positive over-current event.
